Europäisches Patentamt

European Patent Office

Office européen des brevets

(19)

(11) Veröffentlichungsnummer: **0 399 361**
**A2**

(12) # EUROPÄISCHE PATENTANMELDUNG

(21) Anmeldenummer: **90109258.5**

(22) Anmeldetag: **16.05.90**

(51) Int. Cl.⁵: **H01L 31/18, H01L 33/00**

(30) Priorität: **24.05.89 DE 3916966**

(43) Veröffentlichungstag der Anmeldung:
**28.11.90 Patentblatt 90/48**

(84) Benannte Vertragsstaaten:
**DE FR GB IT**

(71) Anmelder: **Siemens Aktiengesellschaft**
**Wittelsbacherplatz 2**
**D-8000 München 2(DE)**

(72) Erfinder: **Westermeier, Heinz, Dipl.-Ing.**
**Jos.-Kyrein-Strasse 9c**
**D-8014 Neubiberg(DE)**
Erfinder: **Heinen, Jochen, Dr.-Ing.**
**Dianastrasse 38**
**D-8013 Haar(DE)**

(54) **Optoelektronisches Bauelement mit optischer Absorberfläche im III-V-Halbleitermaterial.**

(57) Optoelektronisches Bauelement auf einem Substrat (1) aus III-V-Halbleitermaterial, bei dem an der Rückseite (2) die III-Komponente und die V-Komponente des III-V-Halbleitermaterials entmischt sind, um Reflexionen an der Rückseite (2) des Substrates (1) zu vermeiden, und bei dem ein Kontakt (3) auf dieser Rückseite (2) aufgebracht wird, der aus einem Metall oder einer Metallschichtfolge besteht, die das Reflexionsvermögen (2) nicht wesentlich erhöht.

EP 0 399 361 A2

### Optoelektronisches Bauelement mit optischer Absorberfläche im III-V-Halbleitermaterial

Ein bei der Konzipierung von optoelektronischen Bauelementen auftretendes Problem ist die Vermeidung von optischem Nebensprechen, das insbesondere bei einer Kombination mehrerer optoelektronischer Funktionen auf einem monolithischen Halbleiterchip auftreten kann. Dieses störende elektrische und optische Nebensprechen von Signalen zwischen den Schaltungsteilen oder Funktionselementen eines optoelektronischen Bauelementes kann zumal bei transparentem Substratmaterial und in den Fällen, in denen Sender- und Empfangseinheiten eng benachbart liegen, auftreten. Insbesondere bei transparentem Substratmaterial sind besondere Maßnahmen gegen optisches Übersprechen erforderlich, da der Empfangsstörpegel ca. um einen Faktor $10^5$ unter dem Sendepegel liegen muß. Bei nebeneinanderliegenden Schaltungsteilen sind zwei optische Pfade für störende Strahlung von Bedeutung:

1. der direkte Weg von Bauteil zu Bauteil nahe der epitaktischen Oberfläche entlang;

2. der Weg durch das Substrat über eine reflektierende Rückseite des Halbleiterkörpers.

Um dies zu vermeiden, muß die Reflexion dieser Rückseite - im Kristall betrachtet - möglichst gering sein.

In der Druckschrift von E. F. Krimmel e. a.: Fabrication of green-emitting monolithic GaP light-emitting diode displays by laser-induced ablation and ion implantation in J. Appl. Phys. 55, 1617 bis 1618 (1984) ist eine Möglichkeit beschrieben, wie mittels Implantation von Siliziumionen in GaP in der Rückseite eines beschichteten GaP-Substrates eine dünne Schicht amorphen Galliumphosphid hergestellt werden kann, um diese Substratrückseite lichtabsorbierend zu machen. Bei dem dort beschriebenen Verfahren handelt es sich um die Herstellung einer GaP-LED.

Bei derartigen Verfahren zur Veränderung der Oberflächenschicht eines Festkörpers erhält diese Oberfläche Unebenheiten, wie sie z. B. in dem Übersichtsartikel von Z. W. Kowalski: Modification of surface morphology of solids by ion-beam sputtering, J. Mater. Sci. Lett. 6, 1083 bis 1085 (1987) näher beschrieben ist. In dieser Druckschrift werden diese Oberflächenrauhigkeiten mit Ionenstrahl-Sputtern, insbesondere mit einem Argon-Ionenstrahl hergestellt. Zusätzlich zu einer allgemeinen Rauhigkeit der Oberfläche kann durch diese Ionenstrahlbearbeitung eine Verteilung von kegel-, pyramiden- oder säulenförmigen Oberflächenmodifikationen auftreten.

Aufgabe der vorliegenden Erfindung ist es, ein optoelektronisches Bauelement anzugeben, bei dem auf einfache Weise ein optisches Nebensprechen durch von der Rückseite des Substrates reflektierte Strahlung verhindert ist.

Diese Aufgabe ist mit den Merkmalen des Anspruchs 1 gelöst.

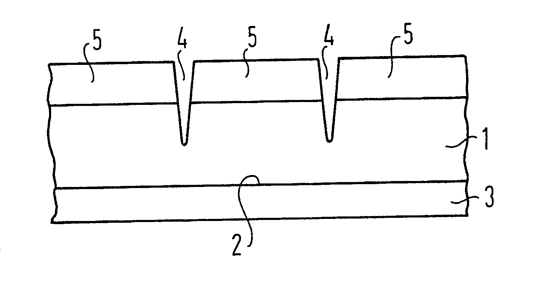

Es folgt eine Beschreibung der erfindungsgemäßen Lösung dieser Aufgabe anhand des in Fig. 1 im Querschnitt schematisch dargestellten Bauelementes.

Die vorliegende Erfindung gibt ein Bauelement mit einem Substrat 1 an, bei dem Reflexion von der Rückseite 2 stark reduziert ist und dadurch dieser optische Nebensprechpfad weitgehend ausgeschaltet ist. Gleichzeitig bleiben andere Funktionen der die Rückseite 2 darstellenden Kristallfläche, wie z.B. elektrische Kontaktfähigkeit und Lötfähigkeit, erhalten. Zu diesem Zweck geht die Erfindung von einem Substrat 1 aus einem III-V-Halbleitermaterial aus. Die Rückseite 2 dieses Substrates 1, d.h. die nicht überwachsene Hauptseite des Substrates 1, weist einen an der Oberfläche befindlichen Schichtanteil auf, in dem die III-Komponente und die V-Komponente des III-V-Halbleitermaterials bis zu einem solchen Grad entmischt sind, daß eine vorgegebene Verminderung der zum Übersprechen führenden Reflexion an dieser rückseitigen Oberfläche bewirkt ist. Diese Entmischung kann dadurch hervorgerufen oder verstärkt sein, daß das III-V-Halbleitermaterial in diesem an der Oberfläche befindlichen Schichtanteil des Substrates 1 zusätzlich an einer der beiden Komponenten verarmt ist. Die in dieser Weise behandelte Rückseite 2 des Substrates 1 ist mit einem Kontakt 3 versehen, der das Reflexionsvermögen nicht oder nur in sehr geringem Maße erhöht.

Die vorgeschlagenen Maßnahmen eignen sich besonders für das Materialsystem InGaAsP/InP. Um die Reflexion von Strahlung insbesondere im Wellenlängenbereich von 1,2 μm bis 1,6 μm an der Rückseite 2 eines Substrates 1 aus InP zu beseitigen, werden unmittelbar an der Oberfläche dieser Rückseite 2 die Komponenten Indium und Phospor entmischt. Das kann z.B. durch Ionenstrahlätzen des Indiumphosphids geschehen. Besonders geeignet für dieses Ionenstrahlätzen ist die Verwendung von Argonionen bei ungekühltem Substrat 1. Dabei entsteht eine mikroskopisch rauhe, braunschwarze Oberfläche. Messungen zeigten, daß das Reflexionsvermögen dieser Fläche auch im interessierenden infraroten Wellenlängenbereich kleiner als 3 % ist. Weiter konnte gezeigt werden, daß durch Aufbringen einer Metallschichtfolge von nacheinander Titan, Platin und Gold auf eine so präparierte Oberfläche des InP-Substrates, das n-dotiert ist, ein genügend leitfähiger ohmscher Kontakt 3 hergestellt werden kann, ohne das Reflexionsvermögen zu erhöhen.

Der Nebensprechpfad an der Oberfläche des Bauelementes zwischen je zwei Funktionselementen 5 kann durch Ätzgräben 4 unterbrochen werden. Die erfindungsgemäße Reflexionsverminderung durch Entmischung der III-Komponente und der V-Komponente kann auch an der Oberfläche dieser Ätzgräben 4 angebracht sein.

**Ansprüche**

1. Optoelektronisches Bauelement auf einem Substrat (1) aus III-V-Halbleitermaterial, **dadurch gekennzeichnet,** daß zur Vermeidung von Reflexionen an der Rückseite (2) des Substrates (1) in einem an dieser Rückseite (2) befindlichen Schichtanteil des III-V-Halbleitermaterials eine Entmischung der III-Komponente und der V-Komponente vorhanden ist.

2. Bauelement nach Anspruch 1 mit Ätzgraben (4), **dadurch gekennzeichnet,** daß die Entmischung der III-Komponente und der V-Komponente zusätzlich an der Oberfläche dieser Atzgräben (4) angebracht ist.

3. Bauelement nach Anspruch 1 oder 2, **dadurch gekennzeichnet,** daß das III-V-Halbleitermaterial InP ist.

4. Bauelement nach einem der Ansprüche 1 bis 3, **dadurch gekennzeichnet,** daß auf der Rückseite (2) ein Kontakt (3) aufgebracht ist, der das Reflexionsvermögen der Rückseite (2) in einem vorgegebenen Wellenlängenbereich maximal um einen vorgegebenen Wert _____ verändert.

5. Bauelement nach Anspruch 4, **dadurch gekennzeichnet,** daß der Kontakt (3) eine Metallschichtfolge ist, die in Richtung vom Substrat (1) weg nacheinander Titan, Platin und Gold aufweist.